# EUROPEAN PATENT SPECIFICATION

(11) **EP 1 719 398 B1**
(45) Date of publication and mention of the grant of the patent: **27.10.2010**
(21) Application number: 05708178.8
(22) Date of filing: 14.02.2005
(51) Int. Cl.: H05K 7/20, G03B 21/16

(54) **PROCEDURE AND APPARATUS FOR CONTROLLING THE TEMPERATURE OF A DISPLAY SURFACE**
PROZEDUR UND VORRICHTUNG ZUR STEUERUNG DER TEMPERATUR EINER DISPLAY-OBERFLÄCHE
PROCEDURE ET APPAREIL DE REGULATION DE LA TEMPERATURE D'UNE SURFACE D'AFFICHAGE

(30) Priority: 16.02.2004 FI 20040239
(43) Date of publication of application: 08.11.2006
(73) Proprietor: Inssimainos OY, 16710 Hollola kk (FI)
(72) Inventor: VIITANEN, Juhani, 16710 Hollola kk (FI)
(74) Representative: Salomäki, Juha Kari Ensio
(86) International application number: PCT/FI2005/000098
(87) International publication number: WO 2005/079129

(56) References cited:
- DE-U1- 20 018 447
- US-A- 5 991 153
- US-B1- 6 226 180

## Description

The present invention relates to a procedure as defined in the preamble of claim 1 and an apparatus as defined in the preamble of claim 5 for controlling the temperature of a display surface. Document US-A-5 991 153 shows a procedure and an apparatus as defined in the preamble of claim 1 and claim 5, respectively.

The procedure and apparatus of the invention, which are hereinafter also referred to by the common designation "solution of the invention", is particularly well applicable for use for controlling the display surface of electric displays, such as TFT, LCD, plasma or similar display devices, either by cooling, heating or in some cases even drying the display surface. This type of electric displays are also referred to as digital displays.

Aforesaid displays provided with a digital display surface have been mainly used in indoor spaces, which is why they have generally been non-encapsulated. The display surface of the display has therefore been in direct contact with ambient air, and consequently it has been impossible to control the temperature of the display surface accurately enough. Still, this type of displays generally work without major problems in indoor spaces because the air circulation rate is sufficiently high to prevent the display surface from becoming overheated. However, as displays used for different purposes have been gaining ground, there has arisen the problem that a bare display surface can not be left exposed to touch by people. Such exposure may lead to damage of the display surface in consequence of vandalism or otherwise due to the surface being accidentally touched with excessive force. For this reason, a display surface that is exposed to touch by people has to be protected with a pane of glass, plastic or equivalent placed in front of the display surface. Often it is also necessary to encapsulate the entire display. However, such encapsulation and protective plate in front of the display surface easily cause overheating of the display surface, which is due to the display's own heat production, the sun or other external heat sources or the combined effect of these. Overheating may reduce the service life of the display if it e.g. causes local damage to the display, or overheating may damage the whole display beyond repair.

Due to the difficult control of temperature of the display surface, it has been difficult to use aforesaid electric displays outdoors where the display surface is more readily exposed e.g. to direct sunshine, which might cause excessive heating of the display surface. Besides, bright sunshine affects the visibility of the display surface. In bright illumination and in sunshine, the display's own brightness has to be increased, and consequently the additional power needed to form the image and increase the contrast produces a higher surface temperature of the display, thus heating the display surface further. Likewise, when used outdoors the display surface may be exposed to other extreme conditions, e.g. rain or low temperatures, in which aforesaid electric displays do not necessarily work without a heating arrangement.

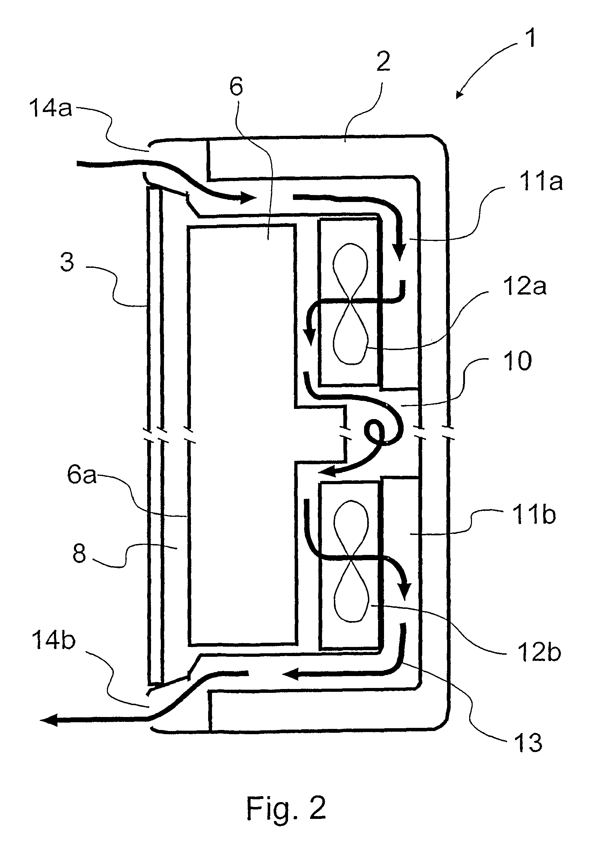

In prior art, international patent application no. WO 01/99482, among others, discloses a solution for cooling an encapsulated electric display. However, the solution according to this WO specification concentrates on cooling the components located in the rear part of the display casing and on cooling the rear part of the plasma display, as is stated on lines 1-10 on page 2 of the WO specification. In addition, from Fig. 2A and 2C of the WO specification we can clearly see that the display surface 21a is outside the casing and the cooling air gap E is on the opposite side of the casing, behind the display 21. Although the display is encapsulated, the display surface in this solution, too, is in direct contact with ambient air, so it is not possible to reliably implement control of the temperature of the display surface, and the display surface is exposed to vandalism and damage from being touched.

Previously known is also a solution as disclosed in British patent application no. GB2357178 for controlling the temperature of a plasma display in a case where the plasma display is enclosed in a hermetic casing provided with a transparent front plate to prevent disturbances caused by dust and other particles present in the air. In the solution according to this GB application, the cooling air is taken through filters directly from the external air surrounding the casing and returned after the cooling function from the casing directly back into the space outside the casing. Therefore, controlling the temperature of the air taken from outside the casing may prove difficult because the temperature of the air may change even very quickly e.g. when the sun emerges from behind a cloud and heats the air. Likewise, displays used outdoors are exposed to large temperature differences in different seasons, and therefore correct control of temperature is difficult. Moreover, in the solution according to the GB application, the air stream is blown into a gap 26 behind the display panel, between the display panel 13 and an auxiliary panel 12 behind the display panel, and not into the gap between the transparent front plate 14 and the actual display surface. Consequently, control of the temperature of the display surface itself is not as fast and efficient as it could be. Besides, in the solution according to the GB application, the air stream is not equalized in any way, so the air stream may be different in respect of cooling/heating power in different parts of the display. In difficult conditions this may result in damage e.g. to a part of the display surface.

Thus, both non-encapsulated displays and partially or completely encapsulated displays still have the common drawback that no reliable arrangement for controlling the temperature of the display surface has been achieved, and consequently the use of electric displays is restricted.

The object of the present invention is to overcome the above-mentioned drawbacks and to achieve a simple and reliable procedure and apparatus for controlling the temperature of the display surface of an electric display, in which solution the display surface of a display placed in a casing can be provided with a protective glass pane or equivalent. A further object is to achieve a procedure and apparatus that will enable the use of an electric display for many different purposes and in many different places of application. The procedure of the invention is characterized by what is disclosed in the characterization part of claim 1. Correspondingly, the apparatus of the invention is characterized by what is disclosed in the characterization part of claim 5. Other embodiments of the invention are characterized by what is disclosed in the other claims.

The solution of the invention has the advantage that, being completely encapsulated, the display device, in more simple terms the display withstands all kinds of external conditions, including exceptional situations, whether caused by weather or man. An additional advantage is that the encapsulated construction with the display surface placed inside a casing enables the control of the temperature of the display surface to be reliably implemented so that the limit temperature values specified by the manufacturer will not be exceeded under any circumstances at any point of the display surface. The advantages resulting from this include a longer service life of the display and more versatile possibilities of use of the display than at present. The display can be used both indoors and outdoors and also at a close distance from spectators as the display surface is protected against touch. A further advantage is that the casing of the display can be easily provided with a cooling system, allowing a display provided with the solution of the invention to be safely used even in reasonably hot outdoor conditions. An additional advantage is good sound insulation of the fans used, because the fans producing the air streams are placed as far away from the front edges of the air ducts opening in the spectator's direction, so that the fan noise carried by the air stream travels through as long a distance in the air duct as possible. Yet another advantage is that the closed box-type structure also protects the display from dust, sand, water and other harmful materials. A further advantage is that, as a constant dynamic pressure is maintained over the entire width of the display surface, the velocity of the flow of circulated air can be equalized over the entire width of the display surface, so a sufficiently even flow velocity is achieved even in the display surface edge areas having the greatest flow resistance.

In the following, the invention will be described in detail with reference to an embodiment example and the attached drawing, wherein
- Fig. 1: presents a technical solution according to the invention in simplified and diagrammatic form in side view,
- Fig. 2: presents a technical solution according to the invention in simplified and diagrammatic form in top view, and
- Fig. 3: presents a technical solution according to the invention in simplified and diagrammatic form in front view.

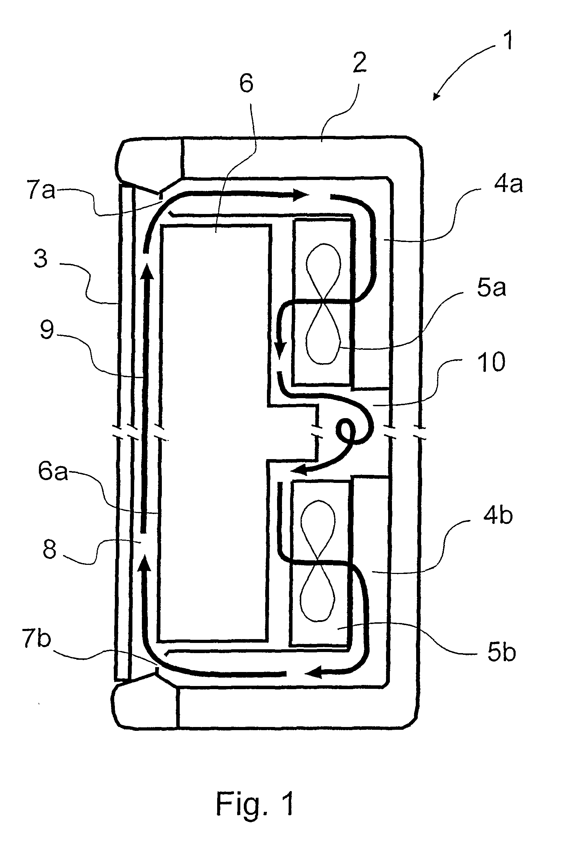

To provide an understanding of the solution of the invention, first a technical solution implementing the procedure of the invention for controlling the temperature of the display surface of an electric display will be described. Fig. 1 presents a simplified and diagrammatic cross-sectional side view of a casing 1 according to the invention. An arrow pattern 9 represents the circulating air stream used to control the temperature of the display surface 6a. The casing structure comprises e.g. a thermally insulated envelope 2, which has an open front provided with a transparent protecting element 3, such as a glass or plastic plate or a corresponding transparent structure. The envelope 2 and the protecting element 3 together form a substantially closed and substantially watertight and airtight casing structure, inside which a display device 6, i.e. a display provided with a display surface 6a can be mounted.

Provided in the upper part of the envelope 2 is an air duct 4a of a width covering substantially the entire interior width of the envelope 2, which air duct forms a hollow structure with an L-shaped cross-sectional profile such that a first branch of the L-profile is substantially parallel to the interior upper surface, i.e. ceiling of the envelope and adjoins the ceiling of the envelope 2 while a second branch of the L-profile is substantially parallel to the interior rear surface, i.e. back wall of the envelope 2 and adjoins the inner surface of the back wall of the envelope. In the lower part of the envelope 2 is an air duct 4b corresponding to air duct 4a and placed in an upside-down position with respect to air duct 4a and adjoining in a corresponding manner both the back wall of the envelope 2 and the interior bottom surface of the envelope 2. The front edges of the first branches of the air ducts 4a and 4b, i.e. the branches at the ceiling and bottom surfaces of the envelope 2 extend to the front part of the envelope 2, close to the rear surface of the protecting element 3.

The air duct 4a in the upper part of the is provided with at least one fan 5a, which sucks air used for controlling the temperature of the display surface 6a from the air duct 4a and blows the air further into a space 10 in the rear part of the envelope 2, which may contain e.g. display components producing turbulence in the circulated air stream. The fan 5a is secured to the second branch of air duct 4a, i.e. to the branch adjoining the rear wall, close to the space 10 in the rear part. Similarly, air duct 4b is provided with a fan 5b secured to the second branch of the air duct, i.e. to the branch adjoining the rear wall. The fan 5b sucks air from the space 10 in the rear part of the envelope 2 into air duct 4b and blows it further through the air duct 4b towards the front part of the envelope 2.

The front part of the air duct 4b in the lower part of the envelope 2 is provided with a throttle element 7b, such as an air gap or equivalent, throttling the circulated air stream and having a width substantially covering at least the entire display surface 6a, the effective cross-sectional area of the throttle element being smaller than the effective cross-sectional area of air duct 4b after fan 5b. Correspondingly, the front part of the air duct 4a in the upper part of the envelope 2 is provided with an exhaust element 7a, such as an air gap or equivalent, for the exhaust of the circulated air stream, said exhaust element having a width at least substantially equal to the entire width of the display surface 6a and an effective cross-sectional area at least equal to the effective cross-sectional area of the throttle element 7b.

The display device 6 is so placed inside the envelope 2 that between the display surface 6a and the protecting element 3 there remains an air gap 8 having a substantially uniform width and oriented in a direction parallel to the plane of the display surface 6a, in which air gap the circulated air stream 9 produced by the fans 5a and 5b has been fitted to rise along the surface of the display surface 6a from the lower part of the envelope 2 to its upper part to control the temperature of the display surface 6a.

Fig. 2 correspondingly presents a simplified and diagrammatic cross-sectional top view of the casing structure 1 of the invention. The arrow pattern 13 indicates the path of the cooling replacement air in the casing structure 1 of the invention. Placed on each interior side surface, i.e. side wall of the envelope 2 has a hollow air duct 11a and 11b of L-shaped cross-sectional profile substantially corresponding to air ducts 4a, 4b. The first branch of the air ducts 11a, 11b adjoins the side wall of the envelope 2 and the second branch adjoins the rear wall of the envelope 2. Air ducts 11a and 11b are mitred with air ducts 4a and 4b and fastened at the mitre to air ducts 4a and 4b, so that the four air ducts together form a structure resembling a picture frame. The hollow interiors of air ducts 4a and 4b are mechanically insulated from the corresponding interiors of air ducts 11a and 11b either at or near the mitre to separate the air streams circulating in the air ducts from each other.

The vertical front side of the envelope 2 is provided with one or more air intake openings 14a communicating with the opening at the front edge of air duct 11a. Air duct 11a is provided with at least one fan 12a, which sucks replacement air into the air duct from outside the of the envelope 2 through the intake opening 14a and blows the air further into the space 10 in the rear part of the envelope 2, where the replacement air stream 13 is mixed with the circulated air stream 9, cooling, heating or drying the circulated air as necessary. In the labyrinthine structure of the space 10 in the rear part, the replacement air is well mixed with the circulated air, so that the temperature of the circulated air is rendered as even as possible. The fan 12a is fastened to the second branch of air duct 11a, i.e. to the branch adjoining the rear wall, close to the space 10 in the rear part. Similarly, air duct 11b is provided with a fan 12b attached to the second branch of the air duct, i.e. to the branch adjoining the rear wall, which sucks air from the space 10 in the rear part of the envelope 2 into air duct 11b and blows it further through the air duct 11b out of the envelope via one or more exhaust openings 14b provided in the vertical front side of the envelope. As the air intake and exhaust openings 14a, 14b are located in the front side of the envelope, the display casing can even be embedded in a wall or a corresponding mounting surface.

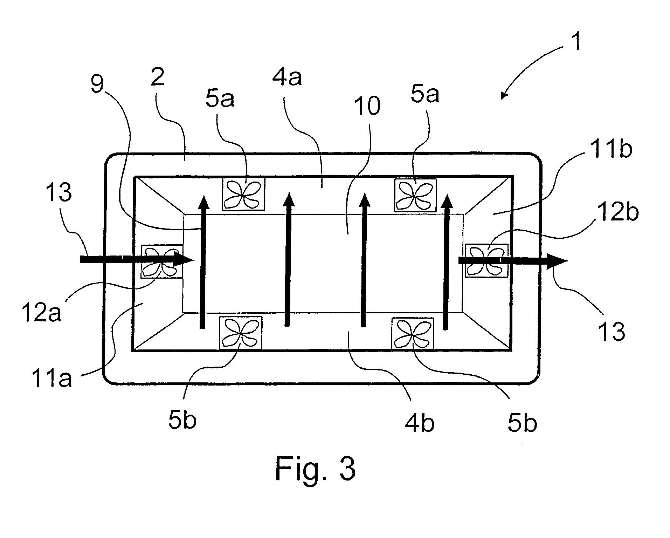

Fig. 3 presents a simplified and diagrammatic cross-sectional front view of the casing structure 1 of the invention. For the sake of clarity, the figure only shows the circulation air 9 flowing upwards along the front side of the display surface 6a of the display device 6. Correspondingly, behind the display device 6 the circulation air 9 flows downwards, as can be seen from Fig. 1. The replacement air stream 13 mainly separated from the circulated air stream 9 is sucked via fan 12a into the space 10 in the rear part, circulated in a substantially horizontal direction and blown out of the casing 1 via fan 12b. Thus, the display surface 6a is never directly exposed to raw air from outside the casing but only to air mixed in the circulated air stream 9. This results in easier and better filtering of the air used to control the temperature of the display surface 6a.

In the casing structure 1 of the invention, the circulating air stream 9 produced by one or more fans 5b creates an overpressure in the lower part of the of air duct 4b, because the cross-section of the throttle element 7b in the fore part of the air duct 4b is smaller than the cross-section of the air duct 4b. The result of this is that the pressure is equalized in the throttle element 7b and the circulating air stream is evenly distributed over the entire width of the throttle element 7b, and therefore a substantially smooth circulated air stream 9 of uniform temperature is flowing at the same velocity through the throttle element 7b, rising upwards in the gap 8 along the display surface 6a of the display device 6.

By means of the circulating air stream 9, the temperature of all pixels on the display surface 6a is controlled by supplying circulation air at a temperature as required in each situation to the display surface 6a at least over the entire width of the display surface and at a sufficiently high flow rate. Placed in the upper part of the air gap 8 and the display surface 6a are one or more temperature sensors, by means of which a correct temperature of the circulating air is maintained. Generally a temperature adjustment of the circulating air stream 9 effected by using the replacement air stream 13 is sufficient. To prepare the casing 1 for difficult conditions, it can be provided with one or more heating elements to heat the circulating air when necessary on the basis of the information obtained from the temperature sensors. Similarly, the casing 1 can be provided with one or more cooling elements to cool the circulating air when necessary on the basis of the information obtained from the temperature sensors if the cooling effected by using the replacement air stream 13 is insufficient. In addition, the apparatus comprises controlling and adjusting elements for keeping the circulating air stream 9 at a correct temperature or within correct temperature limits. For the sake of clarity, the figures do not show the temperature sensors, heating elements, cooling elements and controlling and adjusting elements.

According to the procedure of the invention, the control of the temperature of the display surface 6a of a display device 6 is implemented e.g. as follows: In the procedure, a circulating air stream 9 is circulated inside a substantially closed casing structure 1 by blowing circulation air by means of a fan 5b into an air duct 4b and throttling the flow of the circulation air 9 away from the air duct 4b by means of a throttle element 7b so as to create in the air duct 4b an overpressure equalizing the circulating air stream 9. The overpressurized circulating air stream 9 is passed further via the throttle element 7b at an even flow rate along the display surface 6a of the display device 6 substantially upwards in an air gap 8 between the display surface 6a and a protecting element 3 placed in front of the display surface 6a, at least over the entire width of the display surface 6a. From the air gap 8, the circulating air stream 9 is passed further via an exhaust element 7a into an air duct 4a from which the circulating air stream 9 is sucked by a fan 5a into a space 10 in the envelope 2 behind the display device 6, in which space the circulation air is mixed at least when necessary with replacement air sucked into the envelope 2 from outside the envelope 2 via an air duct 11a by means of a fan 12a to keep the circulating air stream at a desired temperature or within desired temperature limits.

In addition, the circulation and replacement air is used for cooling display device components placed in the space 10 in the rear part. When necessary, the circulating air stream is cooled or heated by means of a separate cooling and/or heating element. The replacement air stream 13 is partially mixed with the circulating air stream 9 and passed out of the envelope 2 via a fan 12b and an air duct 11b. In addition, the circulating air stream 9 and the replacement air stream 13 are prevented form being mixed with each other except in the space 10 in the rear part of the envelope 2 behind the display device 6.

It is obvious to the person skilled in the art that the invention is not limited to the embodiments described above but that it may be varied within the scope of the claims presented below. Thus, for example, the structure of the envelope and the structure and number of the air ducts may differ from those described above. Likewise, the placement and number of fans may vary. Similarly, it is obvious that the intake and exhaust of replacement air as well as the circulation as a whole may be implemented in ways differing from those described above. For example, the replacement air can be taken from the side of or from behind the casing, and it can also be exhausted to the side of and behind the casing. The replacement air can also be taken into the casing or exhausted from the casing at a point near an area containing components that require e.g. special cooling. If necessary, the replacement air can also be taken in and exhausted from the same side of the casing.

It is also obvious to the person skilled in the art that the elongated opening presented above as a throttle element may also consist of a series of smaller apertures or holes, which may be disposed in more than one row. The essential point is that the throttle element or equivalent is used to equalize the pressure of the circulating air stream in the air duct and thus to distribute the entire circulating air stream over the entire width of the display surface. It is also obvious that, instead of consisting of aforesaid apertures or holes, the throttle element may also be formed e.g. directly on the basis of the mutual positions and shape of the display device, protecting element and fore part of the air duct. It is likewise obvious to the person skilled in the art that, instead of throttle elements of fixed shape and size, the opening of the throttle element may be adjustable.

It is further obvious to the person skilled in the art that the pressure, velocity or equivalent of the air stream before it flows onto the display surface 6a can also be equalized without an actual throttle part reducing the cross-sectional area of air duct 5b. In this case, using a high power with fan 4b, in the air duct 5b after the fan 4b a pressure is created that has a magnitude such that the whole air duct forms a kind of throttle functioning as an equalizing element and the pressure as well as the rate of flow are equalized before the air stream reaches the lower edge of the display surface 6a. in this case, air duct 5b may have a substantially constant cross-sectional area throughout its length.

It is additionally obvious to the person skilled in the art that the air intake opening 14a at least for the replacement air stream 13 may be provided with a filter to prevent dust and other small particles present in the air from getting into the replacement air stream 13.

It is further obvious that, instead of being formed from plate-like structural elements, the air ducts may also be formed by the components and other structural parts of the apparatus.

## Claims

1. A procedure for controlling the temperature of the display surface (6a) of an encapsulated display device (6), in which procedure the display device is placed inside a casing (1) provided with a transparent protecting element (3), and in which procedure a medium, such as air, is circulated in the casing (1) with at least one fan (5b), and the circulated air stream (9) is equalized before caused to flow over the display device (6), **characterized in that** the flow of the circulated air stream (9) is throttled to equalize the air stream, whereupon the air stream (9) is passed over the display surface (6a) through an air gap (8) between the display surface (6a) and the transparent protecting element (3) in front of the display surface (6a).

2. A procedure according to claim 1, **characterized in that** circulated air stream (9) is throttled to equalize the air stream by means of a throttle element (7b) placed below the display surface (6a).

3. A procedure according to claim 2, **characterized in that** the circulated air stream (9) is passed after the display surface (6a) via an air duct (4a) provided inside the casing (1) into a space (10) in the rear part of the casing (1), in which space the circulated air stream (9) is mixed if necessary with replacement air taken from outside the casing (1), after which space (10) the circulated air stream (9) is passed again through an air duct (4b) provided inside the casing (1) via the throttle element (7b) into the air gap (8) and over the display surface (6a).

4. A procedure according to claim 1, 2 or 3, **characterized in that** the temperature of the circulated air stream (9) is monitored by means of temperature sensors and, when necessary, the circulated air stream (9) is either heated or cooled by means of a separate heating or cooling element.

5. An apparatus for controlling the temperature of the display surface (6a) of an encapsulated display device (6), in which apparatus the display device (6) is placed inside a casing (1) provided with a transparent protecting element (3), and which apparatus is provided with at least one fan (5b) for circulating a medium, such as air, in the casing (1), and with at least one element for equalizing the circulated air stream (9), **characterized in that** the apparatus is provided with at least one throttle element (7b) comprising an opening and functioning as an equalizing element, which equalizing element, as seen in the direction of the circulated air stream (9), is placed between the fan (5b) and the display surface (6a), further **characterized in that** the cross-sectional area of the equalizing element is smaller than the cross-sectional area of the air duct (4b) between the fan (5b) and the equalizing element.

6. An apparatus according to claim 5, **characterized in that** the throttle element (7b) is placed in the casing and that the throttle element (7b) is an elongated opening of a length at least corresponding to the width of the display surface (6a).

7. An apparatus according to claim 5 or 6, **characterized in that** the front wall of the casing (1) consists of a transparent protecting element (3) placed at a horizontal distance from the display surface (6a) of the display device (6) so that the protecting element (3) and the display surface (6a) have an air gap (8) between them through which the circulated air stream (9) is passed over the display surface (6a).

8. An apparatus according to any one of the preceding claims 5-7, **characterized in that**, in addition to the aforesaid components, the casing (1) is provided with at least an aperture-like exhaust element (7a) for exhausting the circulated air stream, an air duct (4a) and a fan (5a) for passing the circulated air stream (9) over the display surface (6a) as a smooth flow inside the casing (1).

9. An apparatus according to any one of the preceding claims 5-8, **characterized in that** the apparatus is provided with air ducts (11a, 11b) and fans (12a, 12b) connected to the air ducts (11a, 11b) for taking in replacement air from outside the casing (1) and mixing it with the circulated air stream (9) in the space (10) in the rear part of the casing and for exhausting it from the casing (1) after the mixing, and that the air ducts (4a, 4b) guiding the circulated air stream (9) are mechanically separated from the air ducts (11a, 11b) guiding the replacement air stream (13).

## Patentansprüche

1. Verfahren zum Steuern der Temperatur der Display-Fläche (6a) einer eingekapselten Display-Vorrichtung (6), in welchem Verfahren die Display-Vorrichtung innerhalb eines Gehäuses (1) platziert ist, das mit einem transparenten Schutzelement (3) versehen ist, und in welchem Verfahren ein Medium, wie beispielsweise Luft, in dem Gehäuse (1) mit mindestens einem Ventilator (5b) zirkuliert wird, und der zirkulierte Luftstrom (9) vergleichmäßigt wird, bevor er zum Überströmen der Display-Vorrichtung (6) gebracht wird, **dadurch gekennzeichnet, dass** die Strömung des zirkulierten Luftstroms (9) gedrosselt wird, um den Luftstrom zu vergleichmäßigen, woraufhin der Luftstrom (9) über die Display-Fläche (6a) durch einen Luftspalt (8) zwischen der Display-Fläche (6a) und dem transparenten Schutzelement (3) vor der Display-Fläche (6a) geführt wird.

2. Verfahren nach Anspruch 1, **dadurch gekennzeichnet, dass** der zirkulierte Luftstrom (9) gedrosselt wird, um den Luftstrom mit Hilfe eines Drosselelements (7b) zu vergleichmäßigen, das hinter der Display-Fläche (6a) angeordnet ist.

3. Verfahren gemäß Anspruch 2, **dadurch gekennzeichnet, dass** der zirkulierte Luftstrom (9) nachfolgend der Display-Fläche (6a) via einem innerhalb des Gehäuses (1) vorgesehenen Luftkanal (4a) in einem Raum (10) in dem Rückteil des Gehäuses (1) geführt wird, in welchem Raum der zirkulierte Luftstrom (9) bei Bedarf mit Ersatzluft gemischt wird, die von außerhalb des Gehäuses (1) genommen wird, nach welchem Raum (10) der zirkulierte Luftstrom (9) wieder durch einen innerhalb des Gehäuses (1) vorgesehenen Luftkanal (4b) geführt wird, via dem Drosselelement (7b) in den Luftspalt (8) und über die Display-Fläche (6a).

4. Verfahren nach Anspruch 1, 2 oder 3, **dadurch gekennzeichnet, dass** die Temperatur des zirkulierten Luftstroms (9) mit Hilfe von Temperatursensoren überwacht wird, und der zirkulierte Luftstrom (9) bei Bedarf mittels separater Wärme- oder Kühlelemente erwärmt oder gekühlt wird.

5. Vorrichtung zum Steuern der Temperatur einer Display Fläche (6a) einer eingekapselten Display-Vorrichtung (6), in welcher Vorrichtung die Display-Vorrichtung (6) innerhalb eines Gehäuses (1) platziert ist, das mit einem transparenten Schutzelement (3) versehen ist, und welche Vorrichtung mit mindestens einem Ventilator (5b) zum Zirkulieren eines Mediums, wie beispielsweise Luft, in dem Gehäuse (1) versehen ist, und mit mindestens einem Element zum Vergleichmäßigen des zirkulierten Luftstroms (9) **dadurch gekennzeichnet, dass** die Vorrichtung mit mindestens einem Drosselelement (7b) versehen ist, das eine Öffnung aufweist und als vergleichmäßigendes Element dient, welches vergleichmäßigende Element aus der Richtung des zirkulierenden Luftstromes (9) gesehen zwischen dem Ventilator (5b) und der Display-Fläche (6a) platziert ist, **ferner dadurch gekennzeichnet, dass** der Querschnittsbereich des vergleichmäßigenden Elements kleiner als der Querschnittsbereich des Luftkanals (4b) zwischen dem Ventilator (5b) und dem vergleichmäßigenden Element ist.

6. Vorrichtung nach Anspruch 5, **dadurch gekennzeichnet, dass** das Drosselelement (7b) in dem Gehäuse platziert ist und dass das Drosselelement (7b) eine langgestreckte Öffnung mit einer Länge hat, die mindestens der Breite der Display-Fläche (6a) entspricht.

7. Vorrichtung nach Anspruch 5 oder 6, **dadurch gekennzeichnet, dass** die Frontwand des Gehäuses (1) aus einem transparenten Schutzelement (3) besteht, das in einem horizontalen Abstand zu der Display-Fläche (6a) der Display-Vorrichtung (6) angeordnet ist, so dass das Schutzelement (3) und die Display-Fläche (6a) einen Luftspalt (8) zwischen ihnen bilden, durch den der zirkulierende Luftstrom (9) über die Display-Fläche (6a) geleitet wird.

8. Vorrichtung nach einem der vorangehenden Ansprüche 5-7, **dadurch gekennzeichnet, dass** zusätzlich zu den zuvor erwähnten Bestandteilen das Gehäuse (1) mit mindestens einem öffnungsförmigen Abströmelement (7a) zum Abgeben des zirkulierten Luftstromes aufweist, einen Luftkanal (4a) und einen Ventilator (5a), um den zirkulierten Luftstrom (9) über die Display-Fläche (6a) als gleichmäßige Strömung innerhalb des Gehäuses (1) zu leiten.

9. Vorrichtung nach einem der vorangehenden Ansprüche 5-8, **dadurch gekennzeichnet, dass** die Vorrichtung mit Luftkanälen (11a, 11b) und Ventilatoren (12a, 12b) versehen ist, die an die Luftkanäle (11a, 11b) zum Ansaugen von Ersatzluft von außerhalb des Gehäuses (1) und zum Durchmischen dieser mit dem zirkulierten Luftstrom (9) in dem Raum (10) in dem Rückteil des Gehäuses angeschlossen sind, sowie zum Abgeben hieraus aus dem Gehäuse (1) nachfolgend dem Durchmischen, und dass die den zirkulierten Luftstrom (9) führenden Luftkanäle (4a, 4b) von den den Ersatz-Luftstrom (13) führenden Luftkanälen (11a, 11b) mechanisch separiert sind.

## Revendications

1. Procédure de régulation de la température de la surface d'affichage (6a) d'un écran encapsulé (6), ledit écran étant, dans le cadre de ladite procédure, placé à l'intérieur d'un boîtier (1) équipé d'un élément de protection transparent (3), et un support, tel que de l'air, étant, dans le cadre de ladite procédure, mis en circulation dans le boîtier (1) à l'aide au moins d'un ventilateur (5b), et le courant d'air mis en circulation (9) étant égalisé avant d'être amené à circuler sur l'écran (6), **caractérisée en ce que** l'écoulement du courant d'air mis en circulation (9) est étranglé afin d'égaliser le courant d'air, après quoi il est fait en sorte que le courant d'air (9) circule sur la surface d'affichage (6a) par l'intermédiaire d'un entrefer (8) situé entre la surface d'affichage (6a) et l'élément de protection transparent (3) devant la surface d'affichage (6a).

2. Procédure selon la revendication 1, **caractérisée en ce que** le courant d'air mis en circulation (9) est étranglé afin d'égaliser le courant d'air au moyen d'un élément d'étranglement (7b) placé sous la surface d'affichage (6a).

3. Procédure selon la revendication 2, **caractérisée en ce qu'il** est fait en sorte que le courant d'air mis en circulation (9) circule après la surface d'affichage (6a) via une conduite d'air (4a) disposée à l'intérieur du boîtier (1) dans un espace (10) situé dans la partie arrière du boîtier (1), le courant d'air mis en circulation (9) étant mélangé si nécessaire, à l'intérieur dudit espace, avec de l'air extérieur pris à partir de l'extérieur du boîtier (1), après ledit espace (10) il est fait en sorte que le courant d'air mis en circulation (9) circule de nouveau au moyen d'une conduite d'air (4b) disposée à l'intérieur du boîtier (1) via l'élément d'étranglement (7b) dans l'entrefer (8) et sur la surface d'affichage (6a).

4. Procédure selon la revendication 1, 2 ou 3, **caractérisée en ce que** la température du courant d'air mis en circulation (9) est surveillée au moyen de sondes de température et, lorsque nécessaire, le courant d'air mis en circulation (9) est soit chauffé soit refroidi au moyen d'un élément de chauffe ou de refroidissement distinct.

5. Appareil de régulation de la température de la surface d'affichage (6a) d'un écran encapsulé (6), dans lequel l'écran (6) est placé à l'intérieur d'un boîtier (1) équipé d'un élément de protection transparent (3), et ledit appareil étant équipé d'au moins un ventilateur (5b) permettant de faire circuler un support, tel que de l'air, dans le boîtier (1), et d'au moins un élément permettant d'égaliser le courant d'air mis en circulation (9), **caractérisé en ce que** l'appareil est équipé d'au moins un élément d'étranglement (7b) comprenant une ouverture et fonctionnant en tant qu'élément d'égalisation, lequel élément d'égalisation, vu dans la direction du courant d'air mis en circulation (9), est placé entre le ventilateur (5b) et la surface d'affichage (6a), **caractérisé en outre en ce que** la superficie en coupe de l'élément d'égalisation est inférieure à la superficie en coupe de la conduite d'air (4b) entre le ventilateur (5b) et l'élément d'égalisation.

6. Appareil selon la revendication 5, **caractérisé en ce que** l'élément d'étranglement (7b) est placé dans le boîtier et **en ce que** l'élément d'étranglement (7b) est une ouverture allongée d'une longueur correspondant au moins à la largeur de la surface d'affichage (6a).

7. Appareil selon la revendication 5 ou 6, **caractérisé en ce que** la paroi avant du boîtier (1) est constituée d'un élément de protection transparent (3) placé à une distance horizontale de la surface d'affichage (6a) de l'écran (6) de manière à ce que l'élément de protection (3) et la surface d'affichage (6a) aient un entrefer (8) situé entre eux par l'intermédiaire duquel il est fait en sorte que le courant d'air mis en circulation (9) circule sur la surface d'affichage (6a).

8. Appareil selon l'une quelconque des revendications 5 à 7 précédentes, **caractérisé en ce que**, en plus des composants susmentionnés, le boîtier (1) est équipé au moins d'un élément d'évacuation de type ouverture (7a) permettant d'évacuer le courant d'air mis en circulation, d'une conduite d'air (4a) et d'un ventilateur (5a) permettant de faire circuler le courant d'air mis en circulation (9) sur la surface d'affichage (6a) en tant qu'écoulement libre à l'intérieur du boîtier (1).

9. Appareil selon l'une quelconque des revendications 5 à 8 précédentes, **caractérisé en ce que** l'appareil est équipé de conduites d'air (11a, 11b) et de ventilateurs (12a, 12b) connectés aux conduites d'air (11a, 11b) afin d'amener l'air extérieur à partir de l'extérieur du boîtier (1) et de le mélanger au courant d'air mis en circulation (9) dans l'espace (10) situé dans la partie arrière du boîtier et afin de l'évacuer du boîtier (1) après le mélange, et **en ce que** les conduites d'air (4a, 4b) guidant le courant d'air mis en circulation (9) sont mécaniquement séparées des conduites d'air (11a, 11b) guidant le courant d'air extérieur (13).
